# EUROPEAN PATENT APPLICATION

(11) **EP 3 065 151 A1**
(43) Date of publication of application: **07.09.2016**
(21) Application number: 14859136.5
(22) Date of filing: 10.10.2014
(51) Int. Cl.: H01F 38/14, H01F 27/28, H01L 23/36

(54) **COMMUNICATION MODULE**

(30) Priority: 30.10.2013 JP 2013225312
(71) Applicant: Nitto Denko Corporation, Ibaraki-shi, Osaka 567-8680 (JP)
(72) Inventor: EBE, Hirofumi, Ibaraki-shi, Osaka 567-8680 (JP); FURUKAWA, Yoshihiro, Ibaraki-shi, Osaka 567-8680 (JP); OOKAWA, Tadao, Ibaraki-shi, Osaka 567-8680 (JP)
(74) Representative: Grünecker Patent- und Rechtsanwälte PartG mbB
(86) International application number: PCT/JP2014/077188
(87) International publication number: WO 2015/064342

(57) **Abstract**

The communication module includes a housing, an element disposed in the housing and generates electric power by a wireless system by induced electricity, a communication circuit that operates based on electric power generated by the element, and a sheet member disposed between the housing and the element and having thermal conductivity and electrical insulation.

## Description

### TECHNICAL FIELD

The present invention relates to a communication module, in particular, to a communication module such as mobile devices.

### BACKGROUND ART

Conventionally, in a communication module such as mobile devices, it has been demanded that heat generated from a heat source such as CPU be released efficiently from the housing to the outside.

For example, Non-Patent Document 1 and 2 disclose a heat-release means such as the following: a graphite sheet having a high thermal conductivity is disposed between the image display device and a communication circuit on which CPU is mounted so as to be in contact with the CPU to dissipate the heat generated from the CPU to the graphite sheet to heat-release.

Meanwhile, recently, a wireless charging mobile device including a wireless charging function using electromagnetic induction in a small mobile device represented by smartphones is in wide use.

The wireless charging mobile device includes, for example, a housing, a coil embedded in the housing side and generates an electromotive force induced by magnetic force received from an external charger, a battery electrically connected to the coil, a communication circuit, and an image display device.

In the wireless charging device as well, a graphite sheet disposed between the communication circuit and the image display device is included as a heat-release means.

### Citation List

### Non-Patent Document

Non-Patent Document 1: Mutsuaki Murakami, "NEW DIAMOND" Vol.29 No. 1 (2013)
Non-Patent Document 2: Tomoyuki Sugimoto, et al., "aluminum" vol. 18, no. 80 (2011)

### SUMMARY OF THE INVENTION

### PROBLEM TO BE SOLVED BY THE INVENTION

However, in the wireless charging mobile device, a coil is mounted as a heat source in addition to the CPU, and therefore more heat-releasing characteristics are demanded.

Therefore, there has been examined that a graphite sheet is further disposed between the housing and the coil.

However, when a graphite sheet is disposed between the housing and the coil, strong magnetic force is applied to the graphite, an electrically conductive material, and as a result, disadvantages such as heat generation from graphite, effects on electromagnetic induction, and reduction in charging efficiency.

An object of the present invention is to provide a communication module with improved heat-releasing characteristics and suppression in reduction in power transmission/reception efficiency in wireless charging.

### MEANS FOR SOLVING THE PROBLEM

A communication module of the present invention includes a housing, an element disposed in the housing and generates induced electromotive force by a wireless system, a communication circuit that operates based on electric power generated by the element, and a sheet member disposed between the housing and the element and having thermal conductivity and electric insulation.

In the communication module of the present invention, it is preferable that the sheet member is formed from a resin composition containing thermal conductive particles and a resin component.

In the communication module of the present invention, it is preferable that the thermal conductive particles are boron nitride.

In the communication module of the present invention, it is preferable that the boron nitride has a flat shape.

In the communication module of the present invention, it is preferable that the resin component contains epoxy resin, phenol resin, and acrylic resin.

In the communication module of the present invention, it is preferable that the sheet member has a thermal conductivity in the surface direction of 30 W/m·K or more.

It is preferable that the communication module of the present invention is a mobile device.

### Effects of the Invention

With the communication module of the present invention, heat-releasing characteristics are excellent, and reduction in power transmission/reception efficiency in wireless charging is suppressed.

### BRIEF DESCRIPTION OF THE DRAWINGS

FIG. 1 shows a cross-sectional view of a communication module of the present invention in an embodiment.
FIG. 2 shows an exploded perspective view of the communication module in the embodiment of FIG. 1.
FIG. 3 shows a cross-sectional view of a communication module of Comparative Example 1.
FIG. 4 shows a cross-sectional view of a communication module of Comparative Example 2.
FIG. 5 shows a schematic view of an examination device for power transmission/reception efficiency evaluation conducted in Examples.

### DESCRIPTION OF EMBODIMENTS

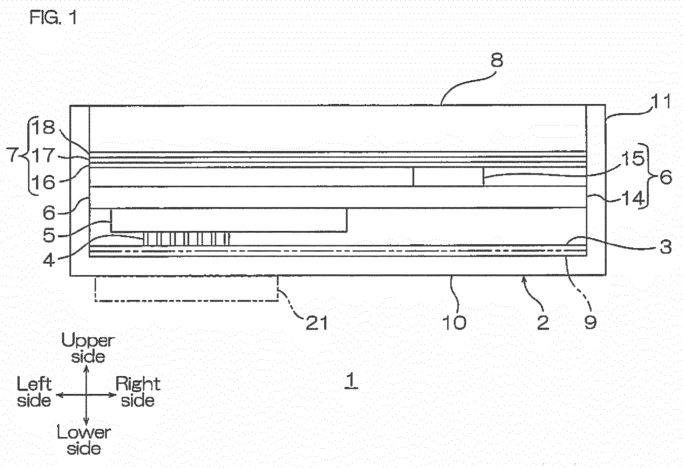

In FIG. 1, the upper side on the plane of the sheet is "upper side" (one side in the first direction, one side in the thickness direction), the lower side on the plane of the sheet is "lower side" (the other side in the first direction, the other side in the thickness direction), the left side on the plane of the sheet is "left side" (one side in the second direction), the right side on the plane of the sheet is "right side" (the other side in the second direction), the further side in the paper thickness direction is "front side" (one side in the third direction), and the nearer side in the paper thickness direction is "rear side" (the other side in the third direction). To be specific, the directions are in conformity with the direction arrows shown in FIG. 1. In figures other than FIG. 1, the directions are in conformity with the directions in FIG. 1.

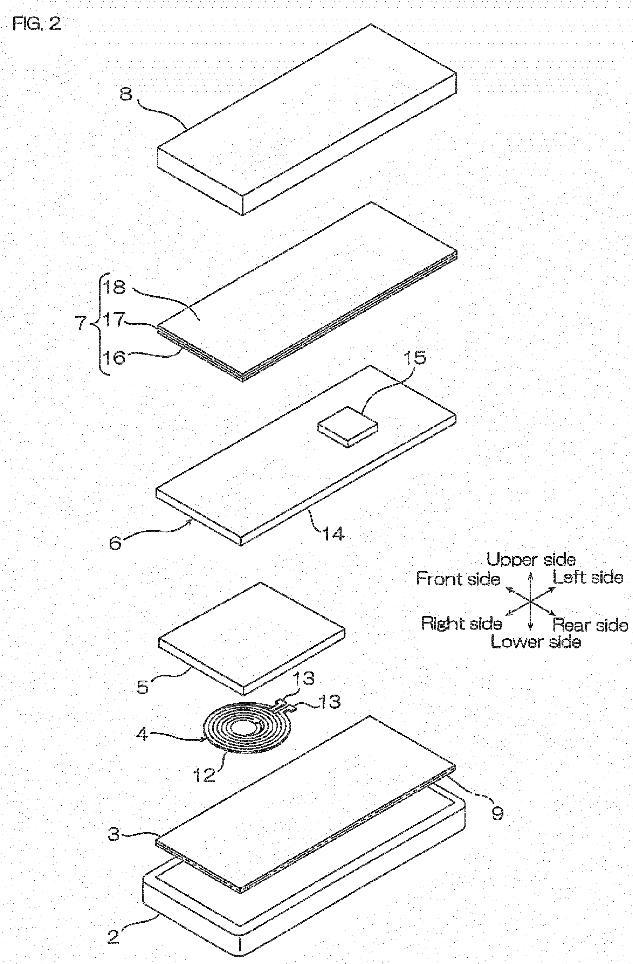

As shown in FIGs. 1 and 2, a communication module 1 includes a housing 2, a sheet member 3 having thermal conductivity and electric insulation, a coil 4 as an element that generates induced electromotive force, a battery 5, a communication circuit 6, a heat-release sheet 7, and an image display device 8.

The housing 2 is a box shape with its upper side open, and includes a base plate 10, and side walls 11 extending upwardly from the peripheral end edge of the base plate 10.

The housing 2 accommodates the sheet member 3, the coil 4, the battery 5, the communication circuit 6, the heat-release sheet 7, and the image display device 8 inside.

The base plate 10 has a generally rectangular shape extending in left-right directions when viewed from the top.

The side wall 11 has a generally rectangular frame shape when viewed from the top, and is formed so that its up-down direction length (height) is about the same with or longer than the total height of the sheet member 3, the coil 4, the battery 5, the communication circuit 6, the heat-release sheet 7, and the image display device 8.

The housing 2 is formed, for example, from resin and/or metal.

For the resin, for example, thermoplastic resin is used. Examples of the thermoplastic resin include polycarbonate, acrylonitrile butadiene styrene copolymer (ABS), polyvinyl chloride, and acrylic resin.

For the metal, for example, aluminum, iron, copper, and stainless steel are used.

The sheet member 3 has a generally rectangular shape extending in left-right directions when viewed from the top, as shown by the solid line in FIG. 1 and FIG. 2, and is formed so as to be included in the inner circumferential edge of the side wall 11 when projected in up-down direction (thickness direction).

The sheet member 3 is accommodated at the lowermost plane in the housing 2. To be specific, the sheet member 3 is disposed inside the housing 2 so as to be in contact with the upper face of the base plate 10 and the inner faces of the side wall 11.

The sheet member 3 is formed, for example, from a thermal conductive resin composition containing thermal conductive particles and a resin component.

Examples of the material that composes the thermal conductive particles include metal-nitrides such as boron nitride, aluminum nitride, silicon nitride, and gallium nitride; metal oxides such as silicon dioxide, aluminum oxide, magnesium oxide, titanium oxide, zinc oxide, tin oxide, copper oxide, and nickel oxide; hydroxides such as aluminum hydroxide, boehmite, magnesium hydroxide, calcium hydroxide, zinc hydroxide, silicic acid, iron hydroxide, copper hydroxide, and barium hydroxide; hydrated metal oxide such as zirconium oxide hydrate, tin oxide hydrate, basic magnesium carbonate, hydrotalcite, dawsonite, borax, and zinc borate; silicon carbide, calcium carbonate, barium titanate, and potassium titanate. These can be used singly, or two or more of these can be used.

The thermal conductive particles have thermal conductivity and electric insulation.

Preferably, metal nitrides are used, more preferably, boron nitride is used in view of thermal conductivity and electric insulation.

The shape of the thermal conductive particles is not particularly limited as long as they are particles (powder), and examples thereof include bulk shape, needle shape, and flat shape (including flake-like). Examples of the bulk shape include spherical, cuboid, pulverized, or their variants. In view of thermal conductivity, preferably, flat shape is used.

When the particles are flat, the aspect ratio is, for example, 2 or more, preferably 4 or more, and for example, 1000 or less, preferably 200 or less.

The thermal conductive particles have an average particle size (average of maximum length) of, for example, 1 µm or more, preferably 10 µm or more, and for example, 300 µm or less, preferably 100 µm or less.

The average particle size of the thermal conductive particles is measured based on the particle size distribution measured by particle size distribution measurement method of laser scattering method, as a volume-based average particle size, to be more specific, as D50 value (cumulative 50% median diameter).

The thermal conductive resin composition has a thermal conductive particle content based on volume (solid content excluding solvent (that is, thermal conductive particles, resin component, and thermosetting catalyst and other additives contained as necessary)) of, for example, 55% by volume or more, preferably 60% by volume or more, for example, 95% by volume or less, preferably 90% by volume or less. The mass content is, for example, 50 mass% or more, preferably 80 mass% or more, and for example, 98 mass% or less, preferably 95 mass% or less. The mass content in the above-described range allows for a sheet member 3 with excellent thermal conductivity.

For the resin component, any of the thermosetting resin and the thermoplastic resin can be contained, but preferably, thermosetting resin is contained.

Examples of the thermosetting resin include epoxy resin, phenol resin, amino resin, unsaturated polyester resin, polyurethane resin, silicone resin, urea resin, melamine resin, thermosetting polyimide resin, and diallyl phthalate resin. Preferably, epoxy resin and phenol resin are used, more preferably, epoxy resin and phenol resin are used in combination.

Examples of the epoxy resin include those epoxy resins that can be used, for example, as an adhesive composition, including bisphenol epoxy resin (particularly, bisphenol A epoxy resin, bisphenol F epoxy resin, bisphenol S epoxy resin, brominated bisphenol A epoxy resin, hydrogenated bisphenol A epoxy resin, bisphenol AF epoxy resin, etc.), phenol epoxy resin (particularly, phenol novolak epoxy resin, ortho-cresol novolak epoxy resin, etc.), biphenyl epoxy resin, naphthalene epoxy resin, fluorine epoxy resin, trishdroxy phenylmethane epoxy resin, and tetraphenylol ethane epoxy resin. Examples thereof also include hydantoin epoxy resin, trisglycidyl isocyanurate epoxy resin, and glycidylamine epoxy resin. These can be used singly, or can be used in combination of two or more.

Of these examples of epoxy resins, preferably, bisphenol epoxy resin, more preferably, bisphenol A epoxy resin is used.

By containing epoxy resin, excellent reactivity with phenol resin can be achieved, and as a result, the sheet member 3 achieves excellent heat resistance.

The phenol resin is a curing agent for epoxy resin, and examples thereof include novolak phenol resins such as phenol novolak resin, phenol aralkyl resin, cresol novolak resin, tert-butylphenol novolak resin, and nonyl phenol novolak resin; resol phenol resin; and polyoxy styrene such as polyparaoxy styrene. These can be used singly, or can be used in combination of two or more.

Of these examples of phenol resins, preferably, novolak resin, more preferably, phenol novolak resin, phenol aralkyl resin, even more preferably, phenol aralkyl resin is used.

When the hydroxyl equivalent of phenol resin relative to 100 g/eq of epoxy equivalent of the epoxy resin is 1 g/eq or more and less than 100 g/eq, the epoxy resin content relative to 100 parts by mass of the resin component is, for example, 15 parts by mass or more, preferably 30 parts by mass or more, and for example, 70 parts by mass or less, preferably 50 parts by mass or less, and the phenol resin content relative to 100 parts by mass of the resin component is, for example, 5 parts by mass or more, preferably 15 parts by mass or more, and for example, 50 parts by mass or less, preferably 30 parts by mass or less.

When the hydroxyl equivalent of the phenol resin relative to 100 g/eq of epoxy equivalent of the epoxy resin is 100 g/eq or more and less than 200 g/eq, the epoxy resin content relative to 100 parts by mass of the resin component is, for example, 10 parts by mass or more, preferably 25 parts by mass or more, and for example, 50 parts by mass or less, and the phenol resin content relative to 100 parts by mass of the resin component is, for example, 10 parts by mass or more, preferably 25 parts by mass or more, and for example, 50 parts by mass or less.

When the hydroxyl equivalent of the phenol resin relative to 100 g/eq of epoxy equivalent of the epoxy resin is 200 g/eq or more and 1000 g/eq or less, the epoxy resin content relative to 100 parts by mass of the resin component is, for example, 5 parts by mass or more, preferably 15 parts by mass or more, and for example, 30 parts by mass or less, and the phenol resin content relative to 100 parts by mass of the resin component is, for example, 15 parts by mass or more, preferably 35 parts by mass or more, and for example, 70 parts by mass or less.

The epoxy equivalent when two types of epoxy resin are used is an epoxy equivalent of all epoxy resins obtained by multiplying the total amount of the epoxy resin by mass of the epoxy resins, and adding up these.

The hydroxyl equivalent in the phenol resin relative to 1 equivalent of the epoxy group of epoxy resin is, for example, 0.2 equivalent or more, preferably 0.5 equivalent or more, and for example, 2.0 equivalent or less, preferably 1.2 equivalent or less. The amount of the hydroxyl group within the above-described range allows for excellent curing reaction of the sheet member 3 in semi-cured state, and also suppression of degradation.

The resin component has a thermosetting resin content relative to 100 parts by mass of the resin component of, for example, 20 parts by mass or more, preferably 30 parts by mass or more, and for example, 90 parts by mass or less, preferably 80 parts by mass or less, more preferably 60 parts by mass or less.

The resin component preferably contains acrylic resin, in addition to the thermosetting resin. That is, for the resin component, preferably, acrylic resin, epoxy resin, and phenol resin are used in combination. The resin component containing these resins allows for excellent thermal conductivity, electric insulation, and adhesiveness.

Examples of the acrylic resin include an acrylic polymer produced by polymerizing a monomer component of one or more (meth) acrylic acid alkyl ester having a straight chain or branched alkyl group. The "(meth) acryl" represents "acryl and/or methacryl".

Examples of the alkyl group include an alkyl group having 1 to 20 carbon atoms such as a methyl group, ethyl group, propyl group, isopropyl group, n-butyl group, t-butyl group, isobutyl group, amyl group, isoamyl group, hexyl group, heptyl group, cyclohexyl group, 2-ethylhexyl group, octyl group, isooctyl group, nonyl group, isononyl group, decyl group, isodecyl group, undecyl group, lauryl group, tridecyl group, tetradecyl group, stearyl group, octadecyl group, and dodecyl group. Preferably, an alkyl group having 1 to 6 carbon atoms is used.

The acrylic polymer can be a copolymer of (meth) acrylic acid alkyl ester and other monomers.

Examples of the other monomers include glycidyl group-containing monomers such as glycidyl acrylate and glycidyl methacrylate; carboxyl group-containing monomers such as acrylic acid, methacrylic acid, carboxyethyl acrylate, carboxypentyl acrylate, itaconic acid, maleic acid, fumaric acid, and crotonic acid; acid anhydride monomers such as maleic anhydride and itaconic anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate or (4-hydroxymethylcyclohexyl)-methylacrylate; sulfonic acid group-containing monomers such as styrene sulfonic acid, allyl sulfonic acid, 2-(meth) acrylamide-2-methylpropane sulfonic acid, (meth) acrylamide propane sulfonic acid, sulfopropyl (meth) acrylate, and (meth) acryloyloxynaphthalene sulfonic acid; phosphoric acid group-containing monomers such as 2-hydroxyethylacryloyl phosphate; and a styrene monomer and acrylonitrile.

Among these, preferably, glycidyl group-containing monomers, carboxyl group-containing monomers, or hydroxyl group-containing monomers are used. When the acrylic resin is a copolymer of (meth) acrylic acid alkyl ester and these other monomers, that is, when the acrylic resin has a glycidyl group, carboxyl group, or hydroxyl group, the sheet member 3 has excellent heat resistance.

When the acrylic resin is a copolymer of (meth) acrylic acid alkyl ester and other monomers, the mixing ratio (mass) of the other monomer relative to the copolymer is preferably 40 mass% or less.

The acrylic resin has a weight average molecular weight of, for example, 1 × 10⁵ or more, preferably 3 × 10⁵ or more, and for example, 1 × 10⁶ or less. Such a range allows for excellent adhesiveness and heat resistance of the sheet member 3. The weight average molecular weight is measured by gel permeation chromatography (GPC) based on polystyrene standard.

When the resin component contains acrylic resin, the acrylic resin content relative to 100 parts by mass of resin component is, for example, 10 parts by mass or more, preferably 20 parts by mass or more, more preferably 40 parts by mass or more, and for example, 80 parts by mass or less, preferably 70 parts by mass or less. Such a range allows for excellent sheet moldability of the sheet member 3 and adhesiveness of the sheet member 3 in semi-cured state.

The thermal conductive resin composition has a resin component content of, for example, 2 mass% or more, preferably 5 mass% or more, and for example, 50 mass% or less, preferably 15 mass% or less. The above-described range allows for excellent sheet moldability of the sheet member 3.

The resin component can contain resin other than the thermosetting resin and acrylic resin. For the resin other than the thermosetting resin and acrylic resin, for example, thermoplastic resin is used. These resins can be used singly or can be used in combination of two or more.

Examples of the thermoplastic resin include natural rubber, butyl rubber, isoprene rubber, chloroprene rubber, an ethylene-vinyl acetate copolymer, a copolymer, polybutadiene resin, polycarbonate resin, thermoplastic polyimide resin, polyamide resin (6-nylon, 6,6-nylon, etc.), phenoxy resin, saturated polyester resin (PET, PBT, etc.), polyamideimide resin, and fluorine resin.

The thermal conductive resin composition (and also sheet member 3) preferably contains a thermosetting catalyst.

The thermosetting catalyst is not limited as long as the catalyst accelerates curing of the thermosetting resin by heating, and examples thereof include an imidazole compound, triphenylphosphine compound, triphenylborane compound, and amino group-containing compound. Preferably, an imidazole compound is used.

Examples of the imidazole compound include 2-phenylimidazole (trade name; 2PZ), 2-ethyl-4-methylimidazole (trade name; 2E 4MZ), 2-methylimidazole (trade name; 2MZ), 2-undecylimidazole (trade name; C 11Z), 2-phenyl-4,5-dihydroxymethylimidazole (trade name; 2-PHZ), 2-phenyl-1H-imidazole 4,5-dimethanol (trade name; 2PHZ-PW), and 2,4-diamino-6-(2'-methylimidazolyl(1)') ethyl-s-triazine·isocyanuric acid adduct (trade name; 2MAOK-PW) (the above-described products are all manufactured by Shikoku Chemicals Corporation.).

The shape of the thermosetting catalyst can be, for example, spherical or ellipsoid.

The thermosetting catalyst can be used singly, or can be used in combination or two or more.

The mixing ratio of the thermosetting catalyst relative to 100 parts by mass of the resin component is, for example, 0.2 parts by mass or more, preferably 0.3 parts by mass or more, and for example, 5 parts by mass or less, preferably 2 parts by mass or less.

The thermal conductive resin composition can further contain, as necessary, other additives. Examples of the additive include commercially available or known cross-linking agent and inorganic filler.

The thermal conductive resin composition preferably does not substantially contain an electrically conductive material.

Examples of the electrically conductive material include carbon, and metals such as gold, silver, and copper.

The thermal conductive resin composition is prepared by mixing the above-described components at the above-described mixing ratio.

The sheet member 3 can be produced, for example, by a preparation step, in which a solution of a thermal conductive resin composition is prepared by dissolving or dispersing the thermal conductive resin composition in the solvent; a drying step, in which the solution of the thermal conductive resin composition is applied on the surface of the release substrate and dried to produce a sheet member 3a in a semi-cured state; and a heat-pressing step, in which the plurality of semi-cured sheet members 3a are laminated and heat-pressed.

First, the thermal conductive resin composition is dissolved or dispersed in a solvent (preparation step).

Examples of the solvent include organic solvents such as ketones including acetone and methyl ethyl ketone (MEK); esters such as ethyl acetate; amides such as N,N-dimethylformamide; and ethers such as propylene glycol monomethylether. Examples of the solvent also include water-based solvents such as water, and alcohols such as methanol, ethanol, propanol, and isopropanol.

The thermal conductive resin composition solution has a solid content of, for example, 5 mass% or more, preferably 10 mass% or more, and for example, 50 mass% or less, preferably 20 mass% or less.

The thermal conductive resin composition solution is prepared in this manner.

Then, the thermal conductive resin composition solution is applied on the surface of the release substrate and dried (drying step).

Examples of the release substrate include a polyethylene terephthalate (PET) film, polyethylene film, polypropylene film, and paper. To the surface of these examples of the release substrate, a surface treatment is given with, for example, a fluorine release agent, long-chain alkylacrylate release agent, and silicone release agent.

The application method is not particularly limited, and for example, the application can be performed by doctor blade application method, roll application method, screen application method, and gravure application method.

The drying conditions are as follows: the drying temperature is, for example, 70°C or more and 160°C or less, and the drying time is, for example, 1 minute or more and 5 minutes or less.

The sheet member 3a in semi-cured state is produced in this manner.

The sheet member 3a is in semi-cured state (B-stage state) at room temperature (to be specific, 25°C), and is a thermal conductive adhesive sheet having excellent adhesiveness.

The average film thickness of the sheet member 3a (semi-cured state) is, for example, 500 µm or less, preferably 200 µm or less, and for example, 5 µm or more, preferably 50 µm or more.

Then, the produced sheet member 3a in semi-cured state was cut as necessary to produce a plurality of the sheet members 3a, and the plurality of sheet members 3a were laminated in the thickness direction. Thereafter, the plurality of sheet members 3a were heat-pressed with a heat-press in the thickness direction (heat-pressing step). The sheet member 3a in semi-cured state is cured by heat in this manner.

The heat-pressing can be performed using a known press, and examples thereof include a parallel-plate press.

The number of the sheet member 3a (semi-cured state) laminated is, for example, 1 layer or more, preferably 2 layers or more, and for example, 20 layers or less, preferably 5 layers or less. In this manner, the sheet member 3 can be adjusted to a desired thickness.

The heating temperature is, for example, 80°C or more, preferably 100°C or more, and for example, 200°C or less, preferably 175°C or less.

The heating time is, for example, 0.1 hours or more, preferably 0.2 hours or more, and for example, 24 hours or less, preferably 3 hours or less.

The pressure is, for example, 10MPa or more, preferably 20MPa or more, and for example, 500MPa or less, preferably 200MPa or less.

In this manner, the sheet member 3a in semi-cured state is cured by heat, and the sheet member 3 in cured state (C stage state) is produced.

The sheet member 3 has a thickness of, for example, 5 µm or more, preferably 50 µm or more, more preferably 100 µm or more, and for example, 500 µm or less, preferably 250 µm or less, more preferably 200 µm or less.

In the sheet member 3, the thermal conductive particles contained in the sheet member 3 are preferably arranged in the 2-dementional in-plane direction (front-rear-left-right directions)) of the sheet member, by performing the heat-pressing step. That is, preferably, the longitudinal direction (direction perpendicular to the thickness direction) of the flat thermal conductive particles are oriented so as to be along the surface direction of the sheet member 3. Thus, the sheet member 3 is excellent in thermal conductivity.

The sheet member 3 has a thermal conductivity in the surface direction of, for example, 10 W/m·K or more, preferably 30 W/m·K or more, more preferably 40 W/m·K or more, and for example, 500 W/m·K or less, preferably 150 W/m·K or less.

The thermal conductivity is measured by the laser flash method.

The sheet member 3 has a volume resistivity of, for example, 1.0 x 10¹²Ω·cm or more, preferably 1.0 × 10¹⁴Ω·cm or more, more preferably 1.5 × 10¹⁴Ω·cm or more, and for example, 1.0 × 10¹⁸Ω·cm or less, preferably 1.5 × 10¹⁶Ω·m or less.

The volume resistivity is measured by dual-ring-electrode system.

The sheet member 3 can be, for example, a single layer structure composed only of the sheet member 3, as shown with the solid line in FIG. 1, or can be a two-layer structure in which the first adhesive layer 9 is laminated on the lower face of the sheet member 3, as shown with the phantom line in FIG. 1.

Examples of the adhesive that forms the first adhesive layer 9 include those known adhesives that are generally used for adhesives for a circuit board, and for example, an epoxy adhesive, polyimide adhesive, and acrylic adhesive are used.

The first adhesive layer 9 is formed by applying the adhesive on the lower face of the sheet member 3. The first adhesive layer 9 can also be formed by bonding a commercially available double-coated tape formed with the adhesive on the lower face of the sheet member 3.

When the first adhesive layer 9 has the first adhesive layer 9, the first adhesive layer 9 has a thickness of, for example, 1 µm or more, preferably 3 µm or more, and for example, 100 µm or less, preferably 30 µm or less.

The coil 4 is an element that generates induced electromotive force by a wireless system, that is, an element that generates induced electromotive force by magnetic force generated by an external charger (non-contact power transmission device) that is not shown, and is disposed next to the upper side of the sheet member 3. To be specific, the coil 4 is interposed between the upper face of the sheet member 3 and the lower face of the battery 5, so as to be in contact with and face these.

The coil 4 includes a loop coil portion 12, and a pair of connection portion 13 integrally formed at the free end portions of the loop coil portion 12.

The loop coil portion 12 is, for example, spiral, and has a two-layer structure including an upper side coil portion and a lower side coil portion. The upper side coil portion and the lower side coil portion are disposed to face each other with an insulation intermediate sheet interposed therebetween, which is not shown, and a lead at the innermost side of the upper side coil portion is electrically connected to a lead at the innermost side of the lower side coil portion through a via hole, which is not shown. A space is provided between the leads that form the loop coil portion 12.

The two connection portions 13 are formed continuously from the lead at the outermost side of the upper side coil portion and the lower side coil portion, and have a generally rectangular flat shape when viewed from the top. The connection portions 13 are connected to a battery 5 or a communication circuit 6.

The battery 5 is disposed next to the upper side of the coil 4. To be specific, the battery 5 is interposed between the upper face of the coil 4 and the lower face of the communication circuit 6 (described later), and is disposed to face and make contact with these. The battery 5 is connected with the two connection portions 13, and electrically connected with the coil 4.

The battery 5 has a generally rectangular thin plate shape when viewed from the top, and for example, is a known battery 5 used for mobile devices. To be specific, the battery 5 is, for example, secondary batteries such as lithium ion batteries.

The battery 5 has a size of about the half of the sheet member 3, and is disposed at the right end portion of the housing 2.

The communication circuit 6 includes a circuit having a communication function, and for example, as shown in FIGs. 1 and 2, includes a base substrate 14, a circuit pattern (not shown) disposed on the upper face of the base substrate 14, a CPU 15, and a circuit element (not shown).

The base substrate 14 is formed into a generally rectangular shape when viewed from the top, and when projected in up-down direction, has generally the same shape as that of the sheet member 3, and is formed so as to be included inside the side wall 11.

The base substrate 14 is formed, for example, from electrically non-conductive resin such as polyimide, polyester, polyethylene terephthalate, polyethylene naphthalate, and polycarbonate. Furthermore, a resin-covered substrate in which the surface of a ceramic substrate (alumina, aluminum nitride, silicon nitride, etc.) or a metal substrate (aluminum plate, etc.) is covered with an electrically non-conductive resin can also be used.

The circuit pattern is a wiring formed from, for example, conductors such as gold, silver, and copper, and is electrically connected with the coil 4 or the battery 5.

The CPU 15 is a generally rectangular plate slightly smaller than the battery 5 when viewed from the top; is mounted on the upper face of the left end portion of the base substrate 14; and is electrically connected with the circuit pattern. To be specific, the CPU 15 is interposed between the upper face of the base substrate 14 and the lower face of the heat-release sheet 7, and is disposed to face and make contact with these.

The circuit element is mounted on the upper face of the base substrate 14, and is electrically connected with the circuit pattern and the CPU 15. Examples of the circuit element include a condenser, resistor, and wireless communication unit.

The heat-release sheet 7 is formed generally shape when viewed from the top, as shown in FIG. 2, and when projected in up-down direction, has generally the same shape as that of the sheet member 3, and is formed so as to be in frame of the side wall 11. To be specific, the heat-release sheet 7 is formed so as to have the same shape as that of the image display device 8 (described later) when viewed from the top.

The heat-release sheet 7 includes an insulating layer 16, a heat conductive layer 17 laminated on the upper face of the insulating layer 16, and a second adhesive layer 18 laminated on the upper face of the heat conductive layer 17. The insulating layer 16, the heat conductive layer 17, and the second adhesive layer 18 are formed to be the same shape when viewed from the top.

Examples of the insulating layer 16 include electrically non-conductive films such as a polyimide film, polyester film, polyethylene terephthalate (PET) film, polyethylene naphthalate film, and polycarbonate film.

The insulating layer 16 has a thickness of, for example, 1 µm or more, preferably 5 µm or more, and for example, 50 µm or less, preferably 25 µm or less.

Examples of the heat conductive layer 17 include a graphite sheet, and a metal film such as copper foil, silver foil, gold foil, and aluminum foil. Preferably, a graphite sheet is used.

The heat conductive layer 17 has a thickness of, for example, 1 µm or more, preferably 10 µm or more, and for example, 200 µm or less, preferably 100 µm or less.

Examples of the adhesive that forms the second adhesive layer 18 include those adhesives given as examples of the first adhesive layer 9.

The second adhesive layer 18 has a thickness of, for example, 1 µm or more, preferably 5 µm or more, and for example, 100 µm or less, preferably 50 µm or less.

The image display device 8 has a generally rectangular thin box shape when viewed from the top, and is disposed next to the upper side of the heat-release sheet 7. To be specific, the image display device 8 is disposed to face the heat-release sheet 7 so as to make contact with the second adhesive layer 18. The image display device 8 is accommodated inside the housing 2 so that the upper face of the image display device 8 is flush with the upper end face of the side wall 11, and the peripheral end portion of the image display device 8 is in contact with the inside face of the side wall 11.

Examples of the image display device 8 include a liquid crystal display device and an organic EL device.

The communication module 1 can be produced by disposing the above-described components in the above-described order.

When the sheet member 3 is disposed inside the housing 2, as shown in the solid line in FIG. 1, the sheet member 3 can be disposed directly on the base plate 10. Furthermore, by bonding the sheet member 3a in semi-cured state to the housing 2, and curing it by heating, the sheet member 3 in cured state can be allowed to adhere to and disposed in the housing 2.

Furthermore, as shown by the phantom line in FIG. 1, the sheet member 3 can be allowed to adhere to and disposed to the base plate 10 with a known first adhesive layer 9.

Then, by placing the communication module 1 on an external charger 21 shown with the phantom line so as to face the coil 4, the coil 4 generates electric power by electromagnetic induction. That is, the communication module 1 can be charged wirelessly without wired charging. Then, the electric power generated by the coil 4 is charged to the battery 5, and then based on the electric power, the communication circuit 6 operates. The coil 4 generates heat at this time. The CPU 15 generates heat during the communication circuit 6 is in operation.

However, the communication module 1 includes a heat-release sheet 7 disposed between the communication circuit 6 and the image display device 8. Therefore, the heat generated by the CPU 15 can be dissipated to the heat-release sheet 7, and can be efficiently released to the image display device 8 and to the outside. Moreover, the communication module 1 includes a thermal conductive and electrically non-conductive sheet member 3 that is disposed between the housing 2 and the coil 4. Therefore, the heat generated by the coil 4 can be dissipated to the sheet member 3, and can be efficiently released to the housing 2 and to the outside. Furthermore, because the sheet member 3 is electrically insulative, effects from the magnetic force from an external charger 21 can be reduced by the sheet member 3. As a result, reduction in induced electromotive force, and reduction in power transmission/reception efficiency in wireless charging can be suppressed.

The communication module 1 can be suitably used for, for example, a small mobile device having a wireless charging function, to be specific, a mobile phone such as a smartphone, cordless phones, small personal computers, electric shaver, and electric toothbrushes.

Although the heat-release sheet 7 is disposed on the upper side of the communication circuit 6 in the embodiment of FIG. 1, for example, the image display device 8 can be directly disposed on the upper side of the communication circuit 6 without disposing the heat-release sheet 7, although not shown.

Preferably, as shown in the embodiment of FIG. 1, the heat-release sheet 7 is disposed on the upper side of the communication circuit 6. In this manner, the heat-release sheet 7 allows for the heat generated from the CPU 15 mounted on the communication circuit 6 to be efficiently dissipated and released.

### Examples

The present invention is described in further detail in the following with reference to Examples and Comparative Examples, but the present invention is not limited thereto. The numeral values shown in Examples below can be replaced with the numeral values shown in the above-described embodiments (that is, upper limit value or lower limit value).

### Example 1

### (Sheet member)

For the thermal conductive particles, boron nitride particles (manufactured by DENKI KAGAKU KOGYO KABUSHIKI KAISHA, trade name "XGP", flat, average particle size 30 µm) were used. A thermal conductive resin composition was produced by mixing 1150 parts by mass (92 mass%) of thermal conductive particles, 50 parts by mass of acrylate ester polymer, 20 parts by mass of bisphenol A epoxy resin (1), 12 parts by mass of bisphenol A epoxy resin (2), 18 parts by mass of phenol aralkyl resin, and 0.5 parts by mass of thermosetting catalyst, so that the thermal conductive resin composition has a thermal conductive particle content of 65% by volume.

A thermal conductive resin composition solution having a solid content concentration of 12 mass% was prepared by dissolving the thermal conductive resin composition in methyl ethyl ketone.

The thermal conductive resin composition solution was applied on a release substrate (average thickness 50 µm) composed of a polyethylene terephthalate film treated with silicone for release using an applicator, and thereafter, dried at 130°C for 2 minutes.

In this manner, the sheet member 3a in semi-cured state (average thickness of only sheet member 3,120 µm) on which the release substrate was laminated was produced.

The sheet member 3a (semi-cured state) was heat-pressed under conditions of 100MPa and 175°C for 30 minutes, thereby producing a sheet member 3 (cured state) having a thickness of 40 µm. The sheet member 3 was cut into a size of 5 cm × 5 cm.

### (Communication module)

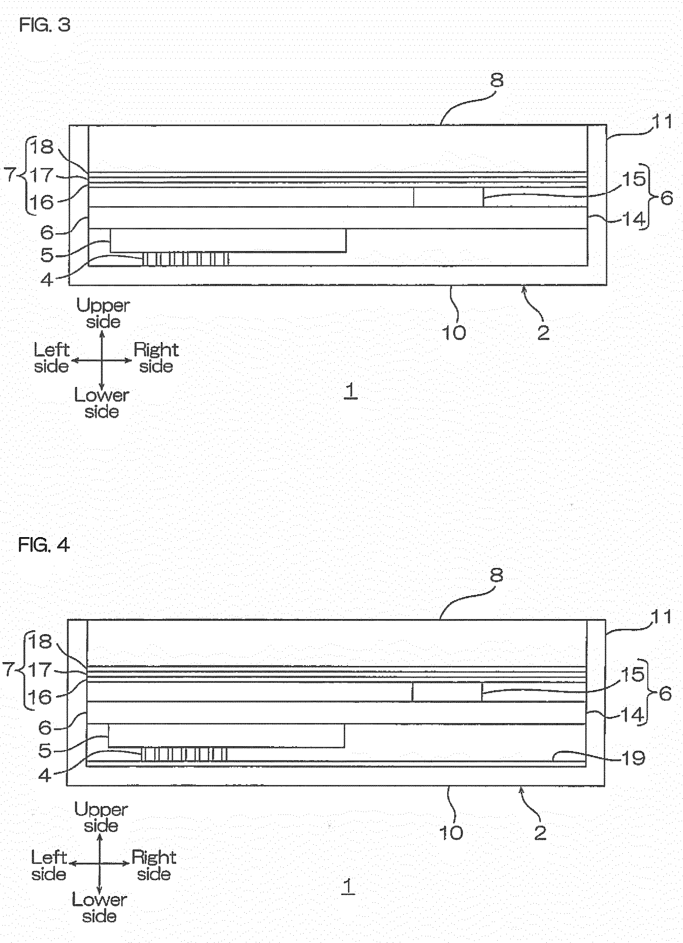

A housing 2 was removed from a commercially available wirelessly charging smartphone (that is, the communication module 1 shown in FIG. 1 without the sheet member 3) shown in FIG. 3. The sheet member 3 produced as described above, and the double-coated tape 9 (first adhesive layer, acrylic adhesive, manufactured by Nitto Denko Corporation, trade name "No. 5610", 5 cm × 5 cm × thickness 10 µm) were disposed in order on a spiral coil 4 (peripheral circle diameter 4 cm, two-layer structure, inductance 10.5 µH, resistance 790 mΩ) embedded in the smartphone. Then, the sheet member 3 on which the coil 4 was provided was attached again to the housing 2 with the first adhesive layer 9 interposed therebetween, thereby producing the communication module 1 in one embodiment of the present invention shown in FIG. 1.

The heat-release sheet 7 is a laminate of a PET film (thickness 10 µm), a graphite sheet (thickness 70 µm), and an acrylic pressure-sensitive adhesive (second adhesive layer, thickness 10 µm).

### Example 2

A communication module 1 was produced in the same manner as in Example 1, except that in Example 1, two sheet members 3 a (semi-cured state) were produced, these sheet members 3 a (excluding release substrate) were laminated, heat-pressed under the conditions of 100MPa and 175°C for 30 minutes, and a sheet member 3 (cured state) having a thickness of 85 µm was produced.

### Example 3

A communication module 1 was produced in the same manner as in Example 2, except that in Example 1, three sheet members 3a (semi-cured state) were laminated and a sheet member 3 (cured state) having a thickness of 130 µm was produced.

### Comparative Example 1

A commercially available wireless charging smartphone shown in FIG. 3 was used as a communication module for Comparative Example 1.

### Comparative Example 2

A communication module was produced (ref: FIG. 4.) in the same manner as in Example 1, except that in Example 1, a graphite sheet 19 (manufactured by Panasonic Corporation, trade name "PGS", thickness 17 µm) was used instead of the sheet member 3.

### (Thermal conductivity measurement)

The sheet member 3 and the graphite sheet 19 used in Examples and Comparative Examples were cut into a 2 cm square, and using a xenon flash analyzer (trade name "LFA 447 nanoflash", manufactured by Netzsch Japan K.K.), the thermal conductivity in the surface direction of the sheet was measured using the laser flash method. The results are shown in Table 1.

### (Electrical insulation measurement)

The sheet member 3 and the graphite sheet 19 used in Examples and Comparative Examples were cut into a 10 cm square, and the volume resistivity (in conformity with JIS-K 6911) of the sheets was measured using a resistivity meter (trade name "Hiresta MCP-HT 450", manufactured by Mitsubishi Chemical Corporation) connected to a measurement unit box. The results are shown in Table 1.

### (Heat-releasing characteristics evaluation)

The component composed of the housing 2, double-coated tape 9, sheet member 3, and spiral coil 4 was removed from the communication module 1 produced in Examples, and a black tape (heat emissivity 0.95) was bonded to both sides (surface of the housing 2 and surface of the spiral coil 4) of the component, thereby producing a sample for heat-releasing evaluation.

In Comparative Example 1, the component composed of the housing 2 and the spiral coil 4 was removed, and a black tape (heat emissivity 0.95) was bonded to both sides of the component, thereby producing a sample for heat-releasing evaluation for Comparative Example 1.

In Comparative Example 2, the component composed of the housing 2, double-coated tape 9, graphite sheet 19, and spiral coil 4 was removed, and a black tape (heat emissivity 0.95) was bonded to both sides of the component, thereby producing a sample for heat-releasing evaluation.

Then, an electric current of 1A with a frequency of 120kHz was applied to the spiral coil 4 of these samples for heat-releasing evaluation, and the temperature of the housing 2 was measured with a thermography. The results are shown in Table 1.

### (Power transmission/reception efficiency evaluation)

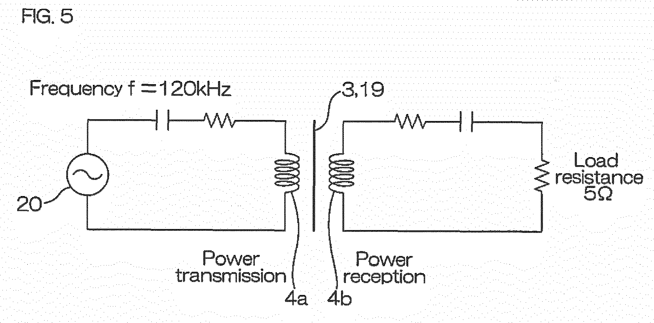

The spiral coil 4 (same as the above-described) was used as a power transmission coil 4a and a power receiving coil 4b, and a circuit shown in FIG. 5 was made. A gap of 5 mm was there between the power transmission coil 4a and the power receiving coil 4b. The sheet member 3 produced in Examples was disposed between the power transmission coil 4a and the power receiving coil 4b.

Then, an electric current of 120kHz and 1.25A was applied to the power transmission coil 4a, and the electric power received at the power receiving coil 4b side was measured. Then, the ratio of the electric power received at the power receiving coil 4b side relative to the electric power put from the power source 20 was calculated as power transmission/reception efficiency.

In the evaluation for Comparative Example 1, no component was disposed between the power transmission coil 4a and the power receiving coil 4b, and in the evaluation for Comparative Example 2, a graphite sheet 19 (same as the one as described above) was disposed and the measurement was carried out. The results are shown in Table 1.

**[Table 1]**

| | | Example 1 | Example 2 | Example 3 | Comparative Example 1 | Comparative Example 2 |
|---|---|---|---|---|---|---|
| Sheet member | Thickness (µm) | 40 | 85 | 130 | - | 17 |
| | Thermal conductivity (W/m·K) | 40 | 40 | 40 | - | 100 |
| | Volume resistivity (Ω· cm) | 2.5×10¹⁵ | 3.6×10¹⁵ | 3.8×10¹⁵ | - | 5.0×10⁻⁵ |
| Heat-releasing characteristics | Housing surface temperature (°C) | 48.2 | 46.3 | 43.3 | 54.4 | 54.5 |
| | Temperature change *(°C) | -6.2 | -8.1 | -11.1 | | 0.1 |
| Transmission/ reception efficiency | Received electric power (W) | 7.9 | 7.8 | 8.0 | 8.0 | 6.0 |
| | Efficiency (%) | 66 | 65 | 67 | 67 | 50 |

| | | | | | | |
|---|---|---|---|---|---|---|
| *Shows temperature difference from the housing surface temperature in Comparative Example 1 | | | | | | |

For the components in Examples, the following materials were used.
- Acrylate ester polymer: trade name "Paracron W-197CM", acrylate ester polymer mainly composed of ethyl acrylate-methyl methacrylate, manufactured by Negami Chemical Industirial Co., Ltd.
- bisphenol A epoxy resin (1): trade name "Epikote 1004", epoxy equivalent 875 to 975 g/eq, manufactured by JER,
- Bisphenol A epoxy resin (2): trade name, "Epikote YL 980", epoxy equivalent 180 to 190 g/eq, manufactured by JER
- Phenol aralkyl resin: trade name "Milex XLC-4 L", hydroxyl equivalent 170 g/eq, manufactured by Mitsui Chemicals
- Thermosetting catalyst: trade name "Curezol 2PHZ-PW", 2-phenyl-1H-imidazole 4,5-dimethanol, manufactured by Shikoku Chemicals Corporation.

While the illustrative embodiments of the present invention are provided in the above description, such is for illustrative purpose only and it is not to be construed as limiting in any manner. Modification and variation of the present invention that will be obvious to those skilled in the art is to be covered by the following claims.

### Industrial Applicability

The communication module of the present invention can be suitably used, for example, for a small mobile device including wireless charging functions.

## Claims

1. A communication module comprising:
a housing,
an element disposed in the housing and generates induced electromotive force by a wireless system,
a communication circuit that operates based on electric power generated by the element, and
a sheet member disposed between the housing and the element and having thermal conductivity and electric insulation.

2. The communication module according to Claim 1, wherein the sheet member is formed from a resin composition containing thermal conductive particles and a resin component.

3. The communication module according to Claim 2, wherein the thermal conductive particles are boron nitride.

4. The communication module according to Claim 3, wherein the boron nitride has a flat shape.

5. The communication module according to Claim 2, wherein the resin component contains epoxy resin, phenol resin, and acrylic resin.

6. The communication module according to Claim 1, wherein the sheet member has a thermal conductivity in the surface direction of 30 W/m·K or more.

7. The communication module according to Claim 1, wherein the communication module is a mobile device.
